# EUROPÄISCHE PATENTSCHRIFT

(11) **EP 3 540 530 B1**
(45) Veröffentlichungstag und Bekanntmachung des Hinweises auf die Patenterteilung: **19.10.2022**
(21) Anmeldenummer: 18161986.7
(22) Anmeldetag: 15.03.2018
(51) Int. Cl.: G05B 17/02

(54) **VERFAHREN UND ANORDNUNG ZUM STEUERN EINES TECHNISCHEN SYSTEMS**
METHOD AND ASSEMBLY FOR CONTROLLING A TECHNICAL SYSTEM
PROCÉDÉ ET DISPOSITIF DE COMMANDE D'UN SYSTÈME TECHNIQUE

(43) Veröffentlichungstag der Anmeldung: 18.09.2019
(73) Patentinhaber: Siemens Aktiengesellschaft, 80333 München (DE)
(72) Erfinder: Allmaras, Moritz, 81673 München (DE); Oppelt, Mathias, 90427 Nürnberg (DE); Pirsing, Andreas, 16766 Sommerfeld (DE); Rosen, Roland, 82229 Seefeld (DE); Schenk, Tim, 84034 Landshut (DE); Sohr, Annelie, 81929 München (DE)

(56) Entgegenhaltungen:
- WO-A2-2007/067645
- GB-A- 2 393 528
- US-A1- 2007 129 917
- US-A1- 2011 131 017
- US-A1- 2013 204 587

## Beschreibung

Bei der Steuerung von komplexen technischen Systemen, insbesondere Infrastrukturnetzen, wie z.B. Wassernetzen, Stromnetzen, Logistiknetzen oder Prozessnetzen sowie von Produktionsanlagen, verfahrenstechnischen Anlagen oder Kraftwerken, ist es in der Regel wünschenswert, ein Systemverhalten hinsichtlich vorgegebener Kriterien zu optimieren. Zu diesem Zweck sind häufig Assistenzfunktionen vorgesehen, die direkt in die Steuerungstechnik und den Steuerungsablauf integriert werden. Diese Integration ist oft sehr spezifisch auf die jeweilige Steuerungstechnik bzw. den jeweiligen Steuerungsablauf ausgelegt. Numerische Auswertungen und Optimierungen, die häufig iterativ und auf komplexen Datenstrukturen operieren, können aufgrund der spezifischen Bindung an die konkrete Steuerungstechnik meist nur vereinfacht abgebildet werden.

Bekannte Beispiele derartiger spezifischer Steuerungsoptimierungen sind sogenannte MPC-Regler (MPC: Model Predictive Control). Ein solcher MPC-Regler erfasst Sensorsignale des zu steuernden technischen Systems, führt auf einem in der Regel stark vereinfachten Datenmodell des technischen Systems eine numerische Optimierung durch und gibt als Ergebnis der Optimierung Stellgrößen für steuerbare Komponenten des technischen Systems aus.

Aus der Druckschrift WO 2007/067645 A2 sind ein System und ein Verfahren zum Steuern eines Prozesses bekannt, wobei eine simulierte Ausgabe des Prozesses erzeugt wird, wobei eine Menge von Sollwerten basierend auf gemessenen Eingaben aus dem Prozess und basierend auf der simulierten Ausgabe entwickelt wird, und wobei mehrere Steuerausgaben erzeugt werden, welche konfiguriert sind, um den Prozess basierend auf der Menge von Sollwerten während jedes Betriebszyklus des Prozesssteuerungssystems zu steuern. Die simulierte Ausgabe enthält dabei einen oder mehrere vorhergesagte zukünftige Werte bis zum stationären Zustand des Prozesses.

Es ist Aufgabe der vorliegenden Erfindung, ein Verfahren und eine Anordnung zum Steuern eines technischen Systems, anzugeben, die flexibler einsetzbar sind.

Gelöst wird diese Aufgabe durch ein Verfahren mit den Merkmalen des Patentanspruchs 1, durch eine Anordnung mit den Merkmalen des Patentanspruchs 12, durch ein Computerprogrammprodukt mit den Merkmalen des Patentanspruchs 13 sowie durch ein computerlesbares Speichermedium mit den Merkmalen des Patentanspruchs 14.

Zum Steuern eines technischen Systems, insbesondere eines Infrastrukturnetzes, eines Wassernetzes, eines Stromnetzes, eines Logistiknetzes, eines Prozessnetzes, einer Produktionsanlage, einer verfahrenstechnischen Anlage oder eines Kraftwerkes, das mehrere funktional verknüpfte Systemkomponenten aufweist, greifen mehrere voneinander unabhängig betreibbare Funktionsmodule auf ein gemeinsames Datenmodell zu. Die Funktionsmodule umfassen dabei ein Schnittstellenmodul mit einer Schnittstelle zum technischen System, ein Simulationsmodul sowie ein Ausgabemodul. Das Datenmodell umfasst den Systemkomponenten zugeordnete und entsprechend verknüpfte Datenkomponenten sowie Simulationsmodelldaten für ein Simulationsmodell des technischen Systems. Das Simulationsmodell kann hierbei vorzugsweise ein physikalisches Verhalten des technischen Systems abbilden oder zumindest näherungsweise reproduzieren. Unter einer Simulation sei insbesondere jegliche Ermittlung des dynamischen Verhaltens anhand eines physikalischen Modells des technischen Systems verstanden. Die Funktionsmodule werden durch eine Ablaufsteuerung angesteuert, wobei zwischen der Ablaufsteuerung und einem jeweiligen Funktionsmodul dem Funktionsmodul zugeordnete Selektionsdaten übertragen werden, anhand derer das jeweilige Funktionsmodul Modelldaten des Datenmodells selektiert und auf die selektierten Modelldaten zugreift. Das Schnittstellenmodul erfasst fortlaufend Betriebsdaten des technischen Systems und speichert diese durch selektionsdatenspezifischen Zugriff im Datenmodell. Das Simulationsmodul liest die Betriebsdaten sowie Simulationsmodelldaten durch selektionsdatenspezifischen Zugriff aus dem Datenmodell aus und ermittelt anhand der ausgelesenen Betriebsdaten und der Simulationsmodelldaten ein dynamisches Verhalten des technischen Systems. Simulationsdaten über das ermittelte dynamische Verhalten werden vom Simulationsmodul durch selektionsdatenspezifischen Zugriff im Datenmodell gespeichert. Das Ausgabemodul liest die Simulationsdaten durch selektionsdatenspezifischen Zugriff aus dem Datenmodell aus und gibt diese zum Steuern des technischen Systems aus.

Zum Ausführen des erfindungsgemäßen Verfahrens sind eine Anordnung zum Steuern des technischen Systems, ein Computerprogrammprodukt sowie ein computerlesbares Speichermedium vorgesehen. Die Anordnung kann insbesondere eine Steuereinrichtung, ein Assistenzsystem oder eine andere zum Steuern des technischen Systems beitragende Einrichtung sein.

Das erfindungsgemäße Verfahren sowie die erfindungsgemäße Anordnung können beispielsweise mittels eines oder mehrerer Prozessoren, anwendungsspezifischer integrierter Schaltungen (ASIC), digitaler Signalprozessoren (DSP) und/oder sogenannter "Field Programmable Gate Arrays" (FPGA) ausgeführt bzw. implementiert werden.

Ein Vorteil der Erfindung ist insbesondere darin zu sehen, dass für die Funktionsmodule kein direkter Datenaustausch untereinander erforderlich ist. Die Funktionsmodule müssen sich gewissermaßen nicht kennen, so dass sich ihre gegenseitige Abhängigkeit wesentlich reduzieren kann. Damit kann die Erfindung in vielen Fällen einfacher und flexibler an unterschiedliche Anforderungen, Steuerungszwecke, Anwendungskontexte und unterschiedliche technische Systeme angepasst und in bestehende Steuerumgebungen und Softwareumgebungen integriert werden.

Vorteilhafte Ausführungsformen und Weiterbildungen der Erfindung sind in den abhängigen Ansprüchen angegeben.

Vorteilhafterweise kann das Datenmodell bereitgestellt werden, indem ein unparametrisiertes Datenmodell mit den Systemkomponenten zugeordneten und entsprechend verknüpften Datenkomponenten anhand von Systemparametern der Systemkomponenten parametrisiert wird. Auf diese Weise können das Datenmodell bzw. dessen Datenkomponenten basierend auf dem unparametrisierten Datenmodell mittels der Systemparameter instanziiert werden.

Weiterhin können die Funktionsmodule durch die Ablaufsteuerung abhängig von den Selektionsdaten und/oder abhängig von der Verknüpfung der Datenkomponenten angesteuert werden. Insbesondere können die Funktionsmodule durch die Ablaufsteuerung in einer von den Selektionsdaten und/oder der Verknüpfung der Datenkomponenten abhängigen Reihenfolge aufgerufen werden.

Nach einer vorteilhaften Ausführungsform der Erfindung kann das dynamische Verhalten im laufenden Betrieb des technischen Systems simuliert werden. Dabei können die Funktionsmodule ein Überwachungsmodul umfassen, das anhand der Simulation einen Zustand des technischen Systems ermittelt und Zustandsdaten über den ermittelten Zustand zum Steuern des technischen Systems ausgibt. Insbesondere kann das Überwachungsmodul Simulationsdaten über das ermittelte dynamische Verhalten durch selektionsdatenspezifischen Zugriff aus dem Datenmodell auslesen und den Zustand des technischen Systems anhand der ausgelesenen Simulationsdaten ermitteln. Auf diese Weise lässt sich mit geringem Aufwand eine Überwachung unterschiedlicher Betriebszustände und Betriebsparameter im laufenden Betrieb des technischen Systems realisieren. Das Simulationsmodul kann gegebenenfalls mit dem Überwachungsmodul identisch sein oder dieses umfassen.

Weiterhin kann das Überwachungsmodul als Prognosemodul implementiert sein, das anhand der Simulation einen zukünftigen Zustand des technischen Systems ermittelt und Zustandsdaten über den ermittelten zukünftigen Zustand zum Steuern des technischen Systems ausgibt. Hierdurch lassen sich mit geringem Aufwand zukünftige Betriebszustände und Betriebsparameter im laufenden Betrieb des technischen Systems prognostizieren. Das Simulationsmodul kann gegebenenfalls mit dem Prognosemodul identisch sein oder dieses umfassen.

Nach einer weiteren vorteilhaften Ausführungsform der Erfindung können die Funktionsmodule ein Optimierungsmodul umfassen. Das Optimierungsmodul kann unterschiedliche Steueraktionen für das technische System generieren, für die unterschiedlichen Steueraktionen jeweils ein hierdurch induziertes dynamisches Verhalten des technischen Systems anhand des Simulationsmodells ermitteln und aus den generierten Steueraktionen eine das induzierte dynamische Verhalten optimierende Steueraktion zum Steuern des technischen Systems ausgeben. Eine solche Steueraktion wird häufig auch als Aktion, als Aktionsgröße oder als Steuergröße bezeichnet und durch Steuerdaten spezifiziert oder repräsentiert. Unter einer Optimierung sei dabei auch eine gezielte Annäherung an ein Optimum verstanden.

Weiterhin kann durch die Ablaufsteuerung eine Reihenfolge, in der Funktionsmodule aufgerufen werden, abhängig von einer Steueranwendung und/oder abhängig von einer zeitlichen, räumlichen, logischen und/oder funktionalen Verknüpfung oder Abhängigkeit von Systemkomponenten, Systemprozessen oder Systemdaten des technischen Systems und/oder von entsprechenden Datenkomponenten und/oder Datensätzen des Datenmodells ermittelt werden. Als Steueranwendung kann insbesondere eine Überwachung des technischen Systems, eine Prognose von zukünftigen Zuständen des technischen Systems, eine Optimierung von Steueraktionen für das technische System oder ein anderer Steuerungszweck vorgesehen sein.

Ferner können die Funktionsmodule ein Sensormodul umfassen, das das technische System betreffende Sensordaten durch selektionsdatenspezifischen Zugriff im Datenmodell speichert. Die gespeicherten Sensordaten können dann durch ein anderes Funktionsmodul durch selektionsdatenspezifischen Zugriff aus dem Datenmodell ausgelesen und weiterverarbeitet werden.

Darüber hinaus können die Funktionsmodule ein Auswertungsmodul umfassen, das im Rahmen der Steuerung auszuwertende Daten durch selektionsdatenspezifischen Zugriff aus dem Datenmodell ausliest sowie auswertet und ein Auswertungsergebnis durch selektionsdatenspezifischen Zugriff im Datenmodell speichert. Auf diese Weise kann eine Vielzahl unterschiedlicher datenanalytischer und/oder nicht-modellbasierter Funktionen in modularer Weise in das erfinderische Konzept integriert werden.

Weiterhin können eines oder mehrere der Funktionsmodule jeweils als Microservice in einer Edge-Computing-Umgebung und/oder Cloud-Computing-Umgebung ablaufen. Auf diese Weise lassen sich viele Vorteile der genannten Umgebungen für die Steuerung des technischen Systems nutzen.

Nach einer vorteilhaften Weiterbildung der Erfindung kann eine eine Steueranwendung spezifizierende Anwendungsinformation eingelesen werden. Abhängig von der eingelesenen Anwendungsinformation können dann jeweils das Datenmodell umstrukturiert werden, die Selektionsdaten modifiziert werden und/oder die Funktionsmodule durch die Ablaufsteuerung angesteuert werden. Wie oben bereits erwähnt, kann hierbei als Steueranwendung insbesondere eine Überwachung des technischen Systems, eine Prognose von zukünftigen Zuständen des technischen Systems, eine Optimierung von Steueraktionen für das technische System oder ein anderer Steuerungszweck vorgesehen sein. Auf diese Weise kann die Erfindung flexibel an unterschiedliche Steueranwendungen angepasst werden.

Ein Ausführungsbeispiel der Erfindung wird nachfolgend anhand der Zeichnung näher erläutert. Dabei zeigen jeweils in schematischer Darstellung:
- Figur 1: einen Teil eines Wassernetzes als zu steuerndes technisches System und dessen Abbildung auf ein Datenmodell zum Steuern des Wassernetzes und
- Figur 2: eine erfindungsgemäße Anordnung beim Steuern eines technischen Systems.

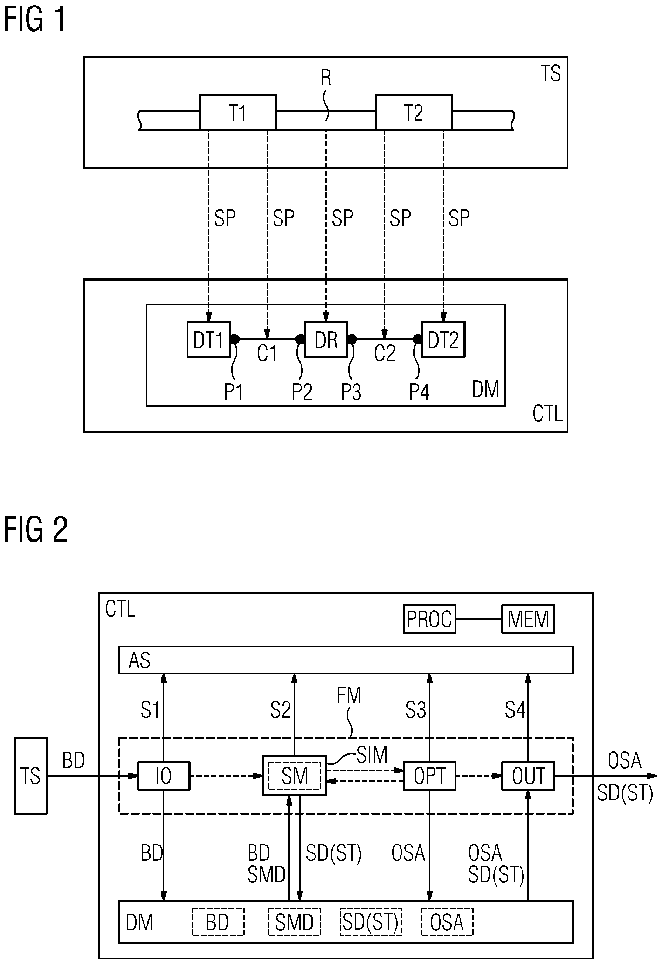

Figur 1 zeigt beispielhaft einen Teil eines Wassernetzes als zu steuerndes technisches System TS und dessen Abbildung auf ein komponenten- und verbindungsorientiertes Datenmodell DM in schematischer Darstellung. Das Datenmodell DM ist Teil einer Steuereinrichtung CTL zum Steuern des Wassernetzes TS. Alternativ oder zusätzlich zum Wassernetz TS kann als technisches System auch ein anderes Infrastrukturnetz, wie z.B. ein Stromnetz, ein Logistiknetz oder ein Prozessnetz, oder eine Produktionsanlage, eine verfahrenstechnische Anlage, ein Kraftwerk oder eine Kombination hiervon vorgesehen sein.

Das technische System TS weist eine Netzwerkstruktur auf, die jeweils eine Vielzahl von verschiedenen funktional verknüpften und technisch interagierenden Systemkomponenten, wie z.B. Wasserleitungen, Stromleitungen, Kraftwerke, Verbraucher, Fertigungsroboter, Förderbänder oder Werkzeugmaschinen umfasst. Die Systemkomponenten können hierbei insbesondere durch einen Materialfluss, Energiefluss und/oder Datenfluss verknüpft sein.

Das im vorliegenden Ausführungsbeispiel betrachtete Wassernetz TS weist als Systemkomponenten Wassertanks T1 und T2 sowie ein die Wassertanks T1 und T2 verbindendes Wasserrohr R auf. Als weitere Systemkomponenten könnten z.B. Wasserpumpen, Verbraucher oder Kläranlagen vorgesehen sein.

Das Wassernetz TS wird durch oder mittels der erfindungsgemäßen Steuereinrichtung CTL gesteuert. Die Steuereinrichtung CTL kann dabei ganz oder teilweise extern zum technischen System TS oder als Teil des technischen Systems TS implementiert sein. Insbesondere kann die Steuereinrichtung CTL als Assistenzsystem zur Unterstützung der Steuerung des technischen Systems TS ausgeprägt sein.

Das technische System TS wird durch das in der Steuereinrichtung implementierte Datenmodell DM gewissermaßen repräsentiert. Das Datenmodell DM bildet hierbei eine tatsächliche Topologie und funktionale Struktur des technischen Systems TS ab, insbesondere der Systemkomponenten, hier T1, T2 und R, und deren funktionalen Verknüpfungen. Vorzugsweise werden physikalische oder chemische Zustände und/oder andere technische Parameter des technischen Systems TS sowie von dessen Systemkomponenten möglichst vollständig durch das Datenmodell DM abgebildet. Letzteres umfasst zu diesem Zweck den Systemkomponenten zugeordnete und entsprechend datentechnisch verknüpfte Datenkomponenten, die die Struktur des technischen Systems TS und seiner Systemkomponenten abbilden.

Im vorliegenden Ausführungsbeispiel wird die Systemkomponente T1 auf die Datenkomponente DT1, die Systemkomponente R auf die Datenkomponente DR und die Systemkomponente T2 auf die Datenkomponente DT2 abgebildet.

Darüber hinaus werden funktionale Verknüpfungen oder Verbindungen der Systemkomponenten, hier T1, T2 und R, auf korrespondierende datentechnische Verknüpfungen bzw. Verbindungen der Datenkomponenten, hier DT1, DT2 und DR, abgebildet.

Im vorliegenden Ausführungsbeispiel wird die funktionale Verknüpfung zwischen dem Wassertank T1 und dem Wasserrohr R auf eine datentechnische Verknüpfung C1 zwischen den Datenkomponenten DT1 und DR abgebildet und die funktionale Verknüpfung zwischen dem Wasserrohr R und dem Wassertank T2 auf eine datentechnische Verknüpfung C2 zwischen den Datenkomponenten DR und DT2 abgebildet. Die Verknüpfung C1 ist hierbei an einen Port P1 der Datenkomponente T1 sowie an einen Port P2 der Datenkomponente DR gekoppelt, während die Verknüpfung C2 an einen Port P3 der Datenkomponente DR sowie an einen Port 4 der Datenkomponente DT2 gekoppelt ist. Die Datenkomponenten DT1, DT2 und DR sowie die datentechnischen Verknüpfungen C1 und C2 geben jeweils technische Parameter sowie physikalische und/oder chemische Zustände der Systemkomponenten T1, T2 bzw. R sowie von deren funktionalen Verknüpfungen bzw. Verbindungen an.

Das Datenmodell DM umfasst insbesondere Simulationsmodelldaten für ein Simulationsmodell des technischen Systems TS. Die Simulationsmodelldaten sind konkrete in den Datenkomponenten abgespeicherte Daten zur Simulation des technischen Systems TS oder seiner Systemkomponenten. Das Datenmodell DM ist hierzu vorzugsweise wie bekannte P&ID-Modelle oder bekannte Systemsimulationsmodelle strukturiert, z.B. mittels Komponententypen, von denen parametrisierte Instanzen erstellt werden können und deren Verknüpfung untereinander eine zur Simulation erforderliche Systemstruktur des technischen Systems TS abbildet.

Im vorliegenden Ausführungsbeispiel wird das Datenmodell DM bereitgestellt, indem ein zunächst unparametrisiertes Datenmodell durch konkrete Systemparameter SP der Systemkomponenten, hier T1, T2 und R parametrisiert wird. Die Systemparameter SP geben hierbei eine tatsächliche Struktur oder tatsächliche Zustände des technischen Systems TS oder seiner Systemkomponenten an, wie z.B. ein Fassungsvermögen eines jeweiligen Wassertanks T1 bzw. T2 und/oder einen Durchmesser des Wasserrohres R. Durch die Parametrisierung, d.h. durch Festlegen der konkreten das technische System TS bzw. dessen Systemkomponenten charakterisierenden Systemparameter SP werden das Datenmodell DM bzw. seine Datenkomponenten, hier DT1, DR und DT2 sowie deren Verknüpfungen C1 und C2 instanziiert.

Die vorstehenden Datenstrukturen können insbesondere anhand eines programmtechnischen Klassenmodells wie dem folgenden instanziiert werden, wobei die Pfeile und Einrückungen eine Vererbungsbeziehung andeuten:
Technische Anlage
-> Komponenten
   -> Parameter
   -> Zustände
   -> Profile
   -> Zugeordnete Komponenten
   -> Koordinaten
-> Verbindungen
   -> Verbundene Komponenten-Ports
   -> Koordinaten
-> Globale Parameter

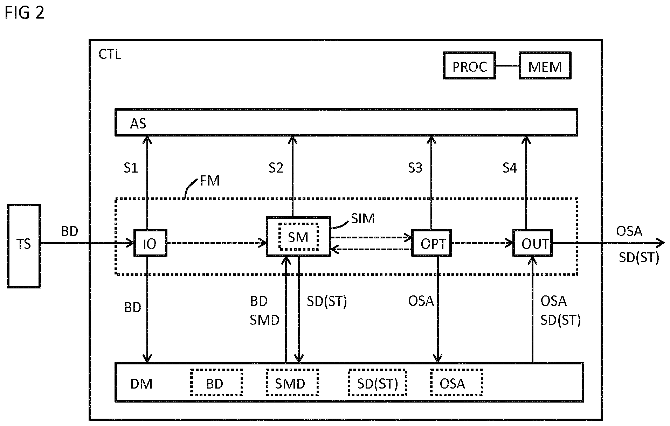

Figur 2 zeigt eine erfindungsgemäße Steuereinrichtung CTL beim Steuern eines technischen Systems TS, z.B. eines Infrastrukturnetzes. Insofern in Figur 2 die gleichen Bezugszeichen wie in Figur verwendet werden, bezeichnen diese Bezugszeichen die gleichen Entitäten. Diese Entitäten können in Funktionszusammenhang von Figur 2 wie im Zusammenhang von Figur 1 beschrieben implementiert oder realisiert werden.

Die Steuereinrichtung CTL verfügt über eine oder mehrere Prozessoren PROC zum Ausführen aller Verfahrensschritte der Steuereinrichtung CTL sowie über eine oder mehrere mit dem Prozessor PROC gekoppelte Speicher MEM zum Speichern der von der Speichereinrichtung CTL zu verarbeitenden Daten.

Die Steuereinrichtung CTL dient zum Steuern des technischen Systems TS. Unter einem Steuern des technischen Systems TS sei hierbei insbesondere auch eine Ausgabe und Verwendung von steuerungsrelevanten, zum Steuern des technischen System TS beitragenden Daten- und Steuersignalen verstanden. Insofern kann die Steuereinrichtung CTL als Assistenzsystem ausgebildet sein.

Die steuerungsrelevanten Daten können insbesondere Steuerdaten, Prognosedaten, Zustandsdaten, Analysedaten, Überwachungsdaten und/oder Klassifikationsdaten umfassen, die insbesondere zur Betriebsoptimierung, Überwachung oder Wartung des technischen Systems TS und/oder zur Verschleißerkennung oder Beschädigungserkennung verwendet werden können.

Die Steuereinrichtung CTL erfasst fortlaufend Betriebsdaten BD des im laufenden Betrieb befindlichen technischen Systems TS. Die Betriebsdaten BD können vom technischen System TS an die Steuereinrichtung CTL übermittelt werden oder durch die Steuereinrichtung CTL anderweitig, z.B. aus einem Datennetz oder mittels Umgebungssensoren erfasst werden.

Als Betriebsdaten können insbesondere physikalische, regelungstechnische, wirkungstechnische und/oder bauartbedingte Betriebsparameter, Betriebsgrößen, Eigenschaftsdaten, Leistungsdaten, Wirkungsdaten, Zustandsdaten, Konfigurationsdaten, Systemdaten, Vorgabewerte, Steuerdaten, Sensordaten, Messwerte, Umgebungsdaten, Überwachungsdaten, Prognosedaten, Analysedaten und/oder andere im Betrieb des technischen Systems TS anfallende, einen Betriebszustand des technischen Systems TS beschreibende und/oder andere für den Betrieb des technischen Systems TS relevante Daten erfasst werden. Dies können beispielsweise Daten über Temperatur, Druck, Emissionen, Vibrationen, Ressourcenverbrauch, Ausbeute etc. sein. Speziell bei einem Wassernetz als technischem System TS können die Betriebsdaten BD eine Flussgeschwindigkeit, eine Flussmenge, einen Druck, einen Füllstand oder eine Pumpleistung betreffen.

Das Datenmodell DM umfasst, wie oben beschrieben, den Systemkomponenten des technischen Systems TS zugeordnete Datenkomponenten, die jedoch in Figur 2 aus Übersichtlichkeitsgründen nicht dargestellt sind. Darüber hinaus umfasst das Datenmodell, wie oben bereits ausgeführt, Simulationsmodelldaten SMD zur Simulation des technischen Systems TS und/oder seiner

Systemkomponenten. Die Simulationsmodelldaten SMD enthalten konkrete für die Simulation relevante Daten und Parameter der Systemkomponenten, die vorzugsweise in der jeweils zugeordneten Datenkomponente des Datenmodells DM gespeichert sind. Die Simulationsmodelldaten SMD repräsentieren insbesondere einen aktuellen Zustand sowie dynamische Eigenschaften des technischen Systems TS.

Die Steuereinrichtung CTL umfasst weiterhin voneinander unabhängig betriebene Funktionsmodule FM, die unabhängig voneinander auf das den Funktionsmodulen FM gemeinsame Datenmodell DM zugreifen. Die Funktionsmodule FM können jeweils unabhängig voneinander anwendungsspezifisch realisiert sein, z.B. zur spezifischen Steuerung von Wassernetzen oder chemischen Produktionsanlagen oder auch anwendungsunabhängig, sofern das jeweilige Funktionsmodul anwendungsübergreifend nutzbar ist.

Die Funktionsmodule FM umfassen im vorliegenden Ausführungsbeispiel ein Schnittstellenmodul IO mit einer Schnittstelle zum technischen System TS sowie ein Simulationsmodul SIM zum Simulieren eines dynamischen Verhaltens des technischen Systems TS im laufenden Betrieb. Das Simulationsmodul SIM implementiert ein Simulationsmodell SM für das technische System TS und führt dieses Simulationsmodell SM aus. Das Simulationsmodell SM bildet insbesondere ein physikalisches Verhalten des technischen Systems TS ab. Die Simulation erfolgt anhand der Simulationsmodelldaten SMD des Datenmodells DM, die konkrete Zustände und Eigenschaften des technischen Systems TS angeben. Bei der Simulation kann insbesondere eine Flusssimulation, eine Logistiksimulation und/oder eine ereignisbasierte, zeitdiskrete Simulation ausgeführt werden.

Weiterhin umfassen die Funktionsmodule FM ein Optimierungsmodul OPT zum Ermitteln einer optimierten Steueraktion für das technische System TS sowie ein Ausgabemodul OUT zum Ausgeben von Steuerdaten. Als Steuerdaten können hierbei insbesondere eine Steueraktion spezifizierende Daten, Simulationsdaten, Überwachungsdaten, Prognosedaten, Zustandsdaten, Stellgrößen, Analysedaten und/oder andere steuerungsrelevante, d.h. zur Steuerung des technischen Systems TS beitragende Daten ausgegeben werden. Die Steuerdaten können vom Ausgabemodul insbesondere an das technische System TS und/oder an eine Benutzerschnittstelle eines Assistenzsystems ausgegeben werden. Im ersten Fall kann das Ausgabemodul OUT vorzugsweise mit dem Schnittstellenmodul IO identisch sein.

Weiterhin können die Funktionsmodule FM ein Sensormodul (nicht dargestellt) zum Erfassen von Sensordaten des technischen Systems TS oder ein oder mehrere Auswertungsmodule (nicht dargestellt) zur Implementierung spezifischer Datenauswertungsfunktionen im Rahmen des erfindungsgemäßen Modulkonzepts umfassen. Durch derartige Auswertungsmodule können mit geringem Aufwand auch nicht-modellbasierte datenanalytische Funktionen integriert werden.

Den obigen Funktionsmodulen FM sind jeweils funktionsmodulspezifische Selektionsdaten zugeordnet und zwar im vorliegenden Ausführungsbeispiel dem Schnittstellenmodul IO Selektionsdaten S1, dem Simulationsmodul SIM Selektionsdaten S2, dem Optimierungsmodul OPT Selektionsdaten S3 sowie dem Ausgabemodul OUT Selektionsdaten S4. Die jeweiligen Selektionsdaten S1, S2, S3 bzw. S4 identifizieren und selektieren für das jeweils zugeordnete Funktionsmodul 10, SIM, OPT bzw. OUT spezifisch und eindeutig jeweils diejenigen Daten im Datenmodell DM, auf die das jeweilige Funktionsmodul zugreifen soll; d.h. diejenigen Daten, welche aus dem Datenmodell DM einzulesen und/oder darin zu speichern sind. Die Selektionsdaten S1,...,S4 können z.B. durch Adressangaben, Datenbankfilter, Datenbankabfragemuster oder Elemente einer modellbasierten Beschreibungssprache, wie z.B. XML realisiert sein.

Anhand der jeweils zugeordneten Selektionsdaten S1,...,S4 selektieren die obigen Funktionsmodule FM jeweils funktionsmodulspezifisch und unabhängig voneinander Modelldaten des Datenmodells DM und greifen so auf die selektierten Modelldaten selektionsdatenspezifisch zu. Auf diese Weise können mittels der Selektionsdaten S1,...,S4 für jedes Funktionsmodul FM dessen Eingabedaten als selektierte Modelldaten aus dem Datenmodell DM spezifisch bereitgestellt und dessen Ausgabedaten als selektierte Modelldaten spezifisch im Datenmodell DM gespeichert werden.

Die Selektionsdaten S1,...,S4 werden von den Funktionsmodulen FM und/oder von einer Ablaufsteuerung AS der Steuereinrichtung CTL bereitgestellt. Die Ablaufsteuerung AS steuert die Funktionsmodule FM an und legt insbesondere deren Aufrufreihenfolge, d.h. einen Prozessfluss für die Funktionsmodule FM fest.

Im vorliegenden Ausführungsbeispiel werden die jeweiligen Selektionsdaten S1, S2, S3 bzw. S4 vom jeweils zugeordneten Funktionsmodul 10, SIM, OPT bzw. OUT bereitgestellt und von diesem jeweils zur Ablaufsteuerung AS übertragen. Alternativ oder zusätzlich können die Selektionsdaten S1,...,S4 in eine funktionsmodulübergreifende Tabelle (nicht dargestellt) eingetragen werden, woraus sie durch die Ablaufsteuerung AS und/oder durch ein jeweiliges Funktionsmodul FM abgerufen werden können.

Gemäß einer weiteren Ausführungsform können die Selektionsdaten von der Ablaufsteuerung AS an die Funktionsmodule FM übermittelt werden. Vorzugsweise werden hierbei aber nur die einem jeweiligen Funktionsmodul zugeordneten Selektionsdaten zu diesem übertragen.

Der Prozessfluss kann durch die Ablaufsteuerung AS problemspezifisch und/oder anwendungsspezifisch gesteuert werden. Dies kann insbesondere abhängig von einer Steueranwendung oder einem Steuerungszweck, abhängig von den Selektionsdaten oder abhängig von den Verknüpfungen der Systemkomponenten und/oder der Datenkomponenten erfolgen. Als Steueranwendung kann z.B. eine Überwachung des technischen Systems TS, eine simulationsgestützte Prognose zukünftiger Zustände des technischen Systems TS oder eine Optimierung von Steueraktionen zur Steuerung des technischen Systems TS vorgesehen sein.

Im vorliegenden Ausführungsbeispiel sollen zukünftige Zustände des technischen Systems TS simulationsgestützt prognostiziert und eine optimierte Steueraktion zum Steuern des technischen Systems TS ermittelt werden. Ein dieser Steueranwendung entsprechender Prozessfluss ist in Figur 2 durch strichliierte Pfeile angedeutet.

Dabei erfasst das Schnittstellenmodul IO fortlaufend die Betriebsdaten BD des technischen Systems TS und speichert diese durch selektionsdatenspezifischen Zugriff mittels der Selektionsdaten S1 im Datenmodell DM. Hierbei werden Betriebsdaten, die von einer jeweiligen Systemkomponente des technischen Systems TS stammen, vorzugsweise in der dieser Systemkomponente jeweils zugeordneten Datenkomponente des Datenmodells DM gespeichert.

Das Simulationsmodul SIM liest die Betriebsdaten BD sowie die Simulationsmodelldaten SMD durch selektionsdatenspezifischen Zugriff mittels der Selektionsdaten S2 aus dem Datenmodell DM aus, simuliert anhand der ausgelesenen Betriebsdaten BD und der Simulationsmodelldaten SMD mittels des Simulationsmodells SM das dynamische Verhalten des technischen Systems TS und ermittelt hierdurch unter anderem einen zukünftigen Zustand des technischen Systems TS. Als Ergebnis werden durch das Simulationsmodul SIM Simulationsdaten SD über das ermittelte dynamische Verhalten und über den zukünftigen Zustand des technischen Systems TS durch selektionsdatenspezifischen Zugriff mittels der Selektionsdaten S2 im Datenmodell DM gespeichert. Die Simulationsdaten SD umfassen hierbei auch spezifische Zustandsdaten ST über den zukünftigen Zustand des technischen Systems TS. Insofern das Simulationsmodul SIM auch einen zukünftigen Zustand ermittelt, fungiert es gewissermaßen auch als Prognosemodul. Alternativ oder zusätzlich können die Funktionsmodule FM zur Ermittlung des zukünftigen Zustands ein separates Prognosemodul umfassen.

Zur Optimierung der Steuerung des technischen Systems TS generiert das Optimierungsmodul OPT eine Vielzahl unterschiedlicher, potentiell ausführbarer Steueraktionen für das technische System TS. Für die generierten Steueraktionen ermittelt das Optimierungsmodul OPT jeweils ein hierdurch induziertes dynamisches Verhalten des technischen Systems TS anhand des Simulationsmodells SM oder anhand eines eigenen physikalischen Modells des technischen Systems TS sowie anhand der Betriebsdaten BD. Ein jeweiliges induziertes dynamisches Verhalten wird durch das Optimierungsmodul OPT nach einem vorgegebenen Kriterium bewertet. Abhängig von diesen Bewertungen wird aus den generierten Steueraktionen diejenige Steueraktion OSA ausgewählt, die das vorgegebene Kriterium optimiert. Das verwendete Kriterium kann z.B. eine Effizienz, eine Ausbeute, einen Ressourcenverbrauch und/oder einen Verschleiß des technischen Systems TS betreffen. Die ausgewählte Steueraktion OSA wird vom Optimierungsmodul OPT durch selektionsdatenspezifischen Zugriff mittels der Selektionsdaten S3 im Datenmodell DM gespeichert.

Das Ausgabemodul OUT liest die Simulationsdaten SD mit den Zustandsdaten ST sowie die optimierende Steueraktion OSA durch selektionsdatenspezifischen Zugriffs mittels der Selektionsdaten S4 aus dem Datenmodell DM aus und gibt die Simulationsdaten SD mit den Zustandsdaten ST sowie die optimierende Steueraktion OSA zum Steuern des technischen Systems TS aus.

Durch die Nutzung voneinander unabhängig verwendbarer und auf ein gemeinsames Datenmodell DM zugreifender Funktionsmodule FM kann die Steuereinrichtung CTL besonders einfach an unterschiedliche Anwendungen angepasst werden. Aufgrund der Unabhängigkeit der Funktionsmodule FM können diese mit geringem Aufwand umstrukturiert oder neu zusammengestellt werden. Dies kann insbesondere abhängig von einer zur Steuereinrichtung CTL übermittelten Anwendungsinformation erfolgen. Letztere kann insbesondere einen Anwendungszweck wie z.B. Überwachung, Prognose oder Optimierung des technischen Systems TS spezifizieren. Darüber hinaus können die Funktionsmodule FM auch als Microservices in Edge-Computing-Umgebungen oder Cloud-Computing-Umgebungen ausgeführt werden.

Durch die erfindungsgemäße Modularisierungsstruktur können eine Vielzahl verfügbarer Softwarefunktionalitäten, Softwarebibliotheken und Softwaremethoden in vorteilhafter Weise genutzt werden, so dass sich ein Implementierungs- und Anpassungsaufwand für derartige Steuereinrichtungen erheblich senken lässt.

## Patentansprüche

1. Verfahren zum Steuern eines technischen Systems (TS) mit mehreren funktional verknüpften Systemkomponenten (T1, T2, R), wobei
a) mehrere voneinander unabhängig betreibbare Funktionsmodule (IO, SIM, OUT) auf ein gemeinsames Datenmodell (DM) zugreifen, wobei
- die Funktionsmodule (IO, SIM, OUT) folgende Funktionsmodule umfassen: ein Schnittstellenmodul (IO) mit einer Schnittstelle zum technischen System (TS), ein Simulationsmodul (SIM) sowie ein Ausgabemodul (OUT), und
- das Datenmodell (DM) den Systemkomponenten zugeordnete und entsprechend verknüpfte Datenkomponenten (DT1, DT2, DR) sowie Simulationsmodelldaten (SMD) für ein Simulationsmodell (SM) des technischen Systems (TS) umfasst,
b) die Funktionsmodule (IO, SIM, OUT) durch eine Ablaufsteuerung (AS) angesteuert werden und zwischen der Ablaufsteuerung (AS) und einem jeweiligen Funktionsmodul (IO, SIM, OUT) dem Funktionsmodul zugeordnete Selektionsdaten (S1,...,S4) übertragen werden, anhand derer das jeweilige Funktionsmodul (IO, SIM, OUT) Modelldaten des Datenmodells (DM) selektiert und auf die selektierten Modelldaten zugreift, wobei Eingabedaten des jeweiligen Funktionsmoduls (IO, SIM, OUT) als selektierte Modelldaten aus dem gemeinsamen Datenmodell (DM) ausgelesen und Ausgabedaten des jeweiligen Funktionsmoduls (IO, SIM, OUT) als selektierte Modelldaten im gemeinsamen Datenmodell (DM) gespeichert werden,
c) das Schnittstellenmodul (IO) Betriebsdaten (BD) des technischen Systems (TS) fortlaufend erfasst und durch selektionsdatenspezifischen Zugriff im Datenmodell (DM) speichert,
d) das Simulationsmodul (SIM) die Betriebsdaten (BD) sowie Simulationsmodelldaten (SMD) durch selektionsdatenspezifischen Zugriff aus dem Datenmodell (DM) ausliest, anhand der ausgelesenen Betriebsdaten (BD) und der Simulationsmodelldaten (SMD) ein dynamisches Verhalten des technischen Systems (TS) ermittelt und Simulationsdaten (SD) über das ermittelte dynamische Verhalten durch selektionsdatenspezifischen Zugriff im Datenmodell (DM) speichert, und
e) das Ausgabemodul (OUT) die Simulationsdaten (SD) durch selektionsdatenspezifischen Zugriff aus dem Datenmodell (DM) ausliest und zum Steuern des technischen Systems (TS) ausgibt.

2. Verfahren nach Anspruch 1, **dadurch gekennzeichnet,**
**dass** das Datenmodell (DM) bereitgestellt wird, indem ein unparametrisiertes Datenmodell mit den Systemkomponenten (T1, T2, R) zugeordneten und entsprechend verknüpften Datenkomponenten (DT1, DT2, DR) anhand von Systemparametern (SP) der Systemkomponenten (T1, T2, R) parametrisiert wird.

3. Verfahren nach einem der vorhergehenden Ansprüche, **dadurch gekennzeichnet,**
**dass** die Funktionsmodule (IO, SIM, OUT) durch die Ablaufsteuerung (AS) abhängig von den Selektionsdaten (S1,...,S4) und/oder abhängig von der Verknüpfung der Datenkomponenten (DT1, DT2, DR) angesteuert werden.

4. Verfahren nach einem der vorhergehenden Ansprüche, **dadurch gekennzeichnet,**
**dass** das dynamische Verhalten im laufenden Betrieb des technischen Systems (TS) simuliert wird, und
**dass** die Funktionsmodule (FM) ein Überwachungsmodul umfassen, das anhand der Simulation einen Zustand des technischen Systems (TS) ermittelt und Zustandsdaten (ST) über den ermittelten Zustand zum Steuern des technischen Systems (TS) ausgibt.

5. Verfahren nach Anspruch 4, **dadurch gekennzeichnet,**
**dass** das Überwachungsmodul ein Prognosemodul ist, das anhand der Simulation einen zukünftigen Zustand des technischen Systems (TS) ermittelt und Zustandsdaten (ST) über den ermittelten zukünftigen Zustand zum Steuern des technischen Systems (TS) ausgibt.

6. Verfahren nach einem der vorhergehenden Ansprüche, **dadurch gekennzeichnet,**
**dass** die Funktionsmodule (FM) ein Optimierungsmodul (OPT) umfassen,
- das unterschiedliche Steueraktionen für das technische System (TS) generiert,
- für die unterschiedlichen Steueraktionen jeweils ein hierdurch induziertes dynamisches Verhalten des technischen Systems (TS) anhand des Simulationsmodells (SM) ermittelt, und
- aus den generierten Steueraktionen eine das induzierte dynamische Verhalten optimierende Steueraktion (OSA) zum Steuern des technischen Systems (TS) ausgibt.

7. Verfahren nach einem der vorhergehenden Ansprüche, **dadurch gekennzeichnet,**
**dass** durch die Ablaufsteuerung (AS) eine Reihenfolge, in der Funktionsmodule (FM) aufgerufen werden,
- abhängig von einer Steueranwendung und/oder
- abhängig von einer zeitlichen, räumlichen, logischen und/oder funktionalen Verknüpfung oder Abhängigkeit von Systemkomponenten, Systemprozessen oder Systemdaten des technischen Systems und/oder von entsprechenden Datenkomponenten und/oder Datensätzen des Datenmodells ermittelt wird.

8. Verfahren nach einem der vorhergehenden Ansprüche, **dadurch gekennzeichnet,**
**dass** die Funktionsmodule (FM) ein Sensormodul umfassen, das das technische System (TS) betreffende Sensordaten durch selektionsdatenspezifischen Zugriff im Datenmodell (DM) speichert.

9. Verfahren nach einem der vorhergehenden Ansprüche, **dadurch gekennzeichnet,**
**dass** die Funktionsmodule (FM) ein Auswertungsmodul umfassen, das im Rahmen der Steuerung auszuwertende Daten durch selektionsdatenspezifischen Zugriff aus dem Datenmodell (DM) ausliest sowie auswertet und ein Auswertungsergebnis durch selektionsdatenspezifischen Zugriff im Datenmodell (DM) speichert.

10. Verfahren nach einem der vorhergehenden Ansprüche, **dadurch gekennzeichnet,**
**dass** eines oder mehrere der Funktionsmodule (FM) jeweils als Microservice in einer Edge-Computing-Umgebung und/oder Cloud-Computing-Umgebung ablaufen.

11. Verfahren nach einem der vorhergehenden Ansprüche, **dadurch gekennzeichnet,**
**dass** eine eine Steueranwendung spezifizierende Anwendungsinformation eingelesen wird, und abhängig von der eingelesenen Anwendungsinformation jeweils
- das Datenmodell (DM) umstrukturiert wird,
- die Selektionsdaten (S1,...,S4) modifiziert werden und/oder
- die Funktionsmodule (FM) durch die Ablaufsteuerung (AS) angesteuert werden.

12. Anordnung (CTL) zum Steuern eines technischen Systems (TS), eingerichtet zum Ausführen eines Verfahrens nach einem der vorhergehenden Ansprüche.

13. Computerprogrammprodukt umfassend Befehle, die bewirken, dass die Anordnung nach Anspruch 12 die Verfahrensschritte nach einem der Ansprüche 1 bis 11 ausführt.

14. Computerlesbares Speichermedium mit einem Computerprogrammprodukt nach Anspruch 13.

## Claims

1. Method for controlling a technical system (TS) having multiple functionally linked system components (T1, T2, R), wherein
a)multiple independently operable functional modules (IO, SIM, OUT) access a common data model (DM), wherein
- the functional modules (IO, SIM, OUT) comprise the following functional modules: an interface module (IO) having an interface to the technical system (TS), a simulation module (SIM) and an output module (OUT), and
- the data model (DM) comprises data components (DT1, DT2, DR) associated with the system components and accordingly linked and simulation model data (SMD) for a simulation model (SM) of the technical system (TS),
b) the functional modules (IO, SIM, OUT) are actuated by a flow controller (AS) and the flow controller (AS) and a respective functional module (IO, SIM, OUT) have selection data (S1,...,S4) associated with the functional module (IO, SIM, OUT) transmitted between them that the respective functional module (IO, SIM, OUT) takes as a basis for selecting model data of the data model (DM) and for accessing the selected model data, wherein input data of the respective functional module (IO, SIM, OUT) are read from the common data model (DM) as selected model data and output data from the respective functional module (IO, SIM, OUT) are stored in the common data model (DM) as selected model data,
c)the interface module (IO) continuously captures operating data (BD) of the technical system (TS) and stores them in the data model (DM) by means of selection-data-specific access,
d)the simulation module (SIM) reads the operating data (BD) and simulation model data (SMD) from the data model (DM) by means of selection-data-specific access, takes the read operating data (BD) and the simulation model data (SMD) as a basis for ascertaining a dynamic response of the technical system (TS) and stores simulation data (SD) about the ascertained dynamic response in the data model (DM) by means of selection-data-specific access, and
e) the output module (OUT) reads the simulation data (SD) from the data model (DM) by means of selection-data-specific access and outputs them to control the technical system (TS).

2. Method according to Claim 1, **characterized in that**
the data model (DM) is provided by virtue of an unparameterized data model with data components (DT1, DT2, DR) associated with the system components (T1, T2, R) and accordingly linked being parameterized on the basis of system parameters (SP) of the system components (T1, T2, R).

3. Method according to either of the preceding claims, **characterized**
**in that** the functional modules (IO, SIM, OUT) are actuated by the flow controller (AS) on the basis of the selection data (S1,...,S4) and/or on the basis of the link of the data components (DT1, DT2, DR).

4. Method according to one of the preceding claims, **characterized**
**in that** the dynamic response is simulated in the course of operation of the technical system (TS), and
**in that** the functional modules (FM) comprise a monitoring module that takes the simulation as a basis for ascertaining a state of the technical system (TS) and outputs state data (ST) about the ascertained state to control the technical system (TS) .

5. Method according to Claim 4, **characterized**
**in that** the monitoring module is a forecast module that takes the simulation as a basis for ascertaining a future state of the technical system (TS) and outputs state data (ST) about the ascertained future state to control the technical system (TS) .

6. Method according to one of the preceding claims, **characterized**
**in that** the functional modules (FM) comprise an optimization module (OPT)
- that generates different control actions for the technical system (TS),
- ascertains for the different control actions a respective dynamic response of the technical system (TS), induced thereby, on the basis of the simulation model (SM), and
- outputs a control action (OSA) from the generated control actions that optimizes the induced dynamic response to control the technical system (TS).

7. Method according to one of the preceding claims, **characterized**
**in that** the flow controller (AS) ascertains an order in which functional modules (FM) are called
- on the basis of a control application and/or
- on the basis of a temporal, spatial, logical and/or functional link or on the basis of system components, system processes or system data of the technical system and/or applicable data components and/or data records of the data model.

8. Method according to one of the preceding claims, **characterized**
**in that** the functional modules (FM) comprise a sensor module that stores sensor data relating to the technical system (TS) in the data model (DM) by means of selection-data-specific access.

9. Method according to one of the preceding claims, **characterized**
**in that** the functional modules (FM) comprise an evaluation module that reads data to be evaluated as part of the control from the data model (DM) by means of selection-data-specific access and evaluates said data and stores an evaluation result in the data model (DM) by means of selection-data-specific access.

10. Method according to one of the preceding claims, **characterized**
**in that** one or more of the functional modules (FM) each run as a microservice in an edge computing environment and/or cloud computing environment.

11. Method according to one of the preceding claims, **characterized**
**in that** application information specifying a control application is read in, and the read-in application information is taken as a basis for, in each case,
- restructuring the data model (DM),
- modifying the selection data (S1,...,S4) and/or
- actuating the functional modules (FM) by means of the flow controller (AS).

12. Arrangement (CTL) for controlling a technical system (TS), set up to perform a method according to one of the preceding claims.

13. Computer program product comprising commands that cause the arrangement according to Claim 12 to perform the method steps according to one of Claims 1 to 11.

14. Computer-readable storage medium having a computer program product according to Claim 13.

## Revendications

1. Procédé destiné à la commande d'un système technique (TS) avec plusieurs composants système (T1, T2, R) reliés de manière fonctionnelle, dans lequel
a) plusieurs modules fonctionnels (IO, SIM, OUT) utilisables de manière indépendante les uns par rapport aux autres accèdent à un modèle de données commun (DM), dans lequel
- les modules fonctionnels (IO, SIM, OUT) comprennent les modules fonctionnels suivants : un module d'interface (IO) avec une interface destinée au système technique (TS), un module de simulation (SIM) ainsi qu'un module de sortie (OUT), et
- le modèle de données (DM) comprend des composants de données (DT1, DT2, DR) associés et reliés de manière correspondante aux composants système ainsi que des données de modèle de simulation (SMD) pour un modèle de simulation (SM) du système technique (TS),
b) les modules fonctionnels (IO, SIM, OUT) sont commandés par le biais d'une commande séquentielle (AS) et des données de sélection (S1, ..., S4) associées au module fonctionnel sont transmises entre la commande séquentielle (AS) et le module fonctionnel (IO, SIM, OUT) respectif, à l'aide de celles-ci le module fonctionnel (IO, SIM, OUT) respectif sélectionne des données de modèle du modèle de données (DM) et accède aux données de modèle sélectionnées, dans lequel des données d'entrée du module fonctionnel (IO, SIM, OUT) respectif sont lues en tant que données de modèle sélectionnées à partir du modèle de données (DM) commun et des données de sortie du module fonctionnel (IO, SIM, OUT) respectif sont mises en mémoire en tant que données de modèle sélectionnées dans le modèle de données (DM) commun,
c) le module d'interface (IO) acquiert des données d'exploitation (BD) du système technique (TS) de manière continue et les met en mémoire par le biais d'un accès spécifique aux données de sélection dans le modèle de données (DM),
d) le module de simulation (SIM) lit les données d'exploitation (BD) ainsi que des données de modèle de simulation (SMD) par le biais d'un accès spécifique aux données de sélection à partir du modèle de données, détermine à l'aide des données d'exploitation (BD) lues et des données de modèle de simulation (SMD) un comportement dynamique du système technique (TS) et met en mémoire dans le modèle de données (DM) des données de simulation (SD) relatives au comportement dynamique déterminé par le biais d'un accès spécifique aux données de sélection, et
e) le module de sortie (OUT) lit à partir du modèle de données (DM) les données de simulation (SD) par le biais d'un accès spécifique aux données de sélection et les émet pour la commande du système technique (TS).

2. Procédé selon la revendication 1, **caractérisé en ce que** le modèle de données (DM) est mis à disposition **en ce qu'**un modèle de données non paramétré est paramétré avec les composants de données (DT1, DT2, DR) associés et reliés de manière correspondante aux composants système (T1, T2, R) à l'aide de paramètres système (SP) des composants système (T1, T2, R).

3. Procédé selon l'une quelconque des revendications précédentes, **caractérisé en ce que** les modèles fonctionnels (IO, SIM, OUT) sont commandés par le biais de la commande séquentielle (AS) en fonction des données de sélection (S1, ..., S4) et/ou en fonction de la liaison des composants de données (DT1, DT2, DR).

4. Procédé selon l'une quelconque des revendications précédentes, **caractérisé en ce que** le comportement dynamique est simulé lors de l'exploitation en cours du système technique (TS) et **en ce que** les modules fonctionnels (FM) comprennent un module de surveillance qui détermine un état du système technique (TS) à l'aide de la simulation et émet des données d'état (ST) relatives à l'état déterminé destiné à la commande du système technique (TS).

5. Procédé selon la revendication 4, **caractérisé en ce que** le module de surveillance est un module de prévision qui détermine un état à venir du système technique (TS) à l'aide de la simulation et émet des données d'état (ST) relatives à l'état à venir déterminé destinées à la commande du système technique (TS).

6. Procédé selon l'une quelconque des revendications précédentes, **caractérisé en ce que** les modules fonctionnels (FM) comprennent un module d'optimisation (OPT)
- qui génère différentes actions de commande pour le système technique (TS),
- qui détermine pour les différentes actions de commande respectivement un comportement dynamique du système technique (TS) induit à cet effet à l'aide du modèle de simulation (SM), et
- qui émet, à partir des actions de commande générées, une action de commande (OSA) optimisant le comportement dynamique induit destinée à la commande du système technique (TS).

7. Procédé selon l'une quelconque des revendications précédentes, **caractérisé en ce que** par le biais de la commande séquentielle (AS) un ordre dans lequel les modules fonctionnels (FM) sont appelés, est déterminé
- en fonction d'une application de commande et/ou
- en fonction d'une liaison temporelle, spatiale, logique et/ou fonctionnelle ou en fonction de composants système, de processus système ou de données système du système technique et/ou de composants de données correspondants et/ou de jeux de données du modèle de données.

8. Procédé selon l'une quelconque des revendications précédentes, **caractérisé en ce que** les modules fonctionnels (FM) comprennent un module de détection qui met en mémoire dans le modèle de données (DM) des données de détection concernant le système technique (TS) par le biais d'un accès spécifique aux données de sélection.

9. Procédé selon l'une quelconque des revendications précédentes, **caractérisé en ce que** les modules fonctionnels (FM) comprennent un module d'évaluation qui lit ainsi qu'il évalue des données à évaluer dans le cadre de la commande par le biais d'un accès spécifique aux données de sélection à partir du modèle de données (DM) et met en mémoire dans le modèle de données (DM) un résultat d'évaluation par le biais d'un accès spécifique aux données de sélection.

10. Procédé selon l'une quelconque des revendications précédentes, **caractérisé en ce qu'**un ou plusieurs des modules fonctionnels (FM) se déroulent en tant que microservice dans un environnement informatique en périphérie et/ou un environnement informatique en nuage.

11. Procédé selon l'une quelconque des revendications précédentes, **caractérisé en ce qu'**une information d'application spécifiant une application de commande est lue et en fonction de l'information d'application lue respectivement
- le modèle de données (DM) est restructuré,
- les données de sélection (S1, ..., S4) sont modifiées et/ou
- les modules fonctionnels (FM) sont commandés par le biais de la commande séquentielle (AS).

12. Dispositif (CTL) destiné à la commande d'un système technique (TS), conçu pour la réalisation d'un procédé selon l'une quelconque des revendications précédentes.

13. Produit de programme informatique comprenant des instructions qui agissent de sorte que le dispositif selon la revendication 12 réalise les étapes de procédé selon l'une quelconque des revendications 1 à 11.

14. Support de stockage lisible sur ordinateur avec un produit de programme informatique selon la revendication 13.
